(19) Europäisches Patentamt
European Patent Office
Office européen des brevets

(11) **EP 4 704 337 A1**

(12) **EUROPEAN PATENT APPLICATION**

(43) Date of publication:
**04.03.2026 Bulletin 2026/10**

(21) Application number: **25184051.8**

(22) Date of filing: **19.06.2025**

(51) International Patent Classification (IPC):
*H03F 3/08* (2006.01)    *H03F 3/45* (2006.01)

(52) Cooperative Patent Classification (CPC):
**H03F 3/08; H03F 3/45475; H03F 2203/45528**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **25.08.2024 US 202418814571**

(71) Applicant: **Aspire Precision Instruments
Ventura, California 93003 (US)**

(72) Inventors:
• **GESKE, Jonathan C.
Ventura, California, 93003 (US)**
• **GESKE, Evan C.
Ventura, California, 93003 (US)**

(74) Representative: **Potter Clarkson
Chapel Quarter
Mount Street
Nottingham NG1 6HQ (GB)**

(54) **DEVICE FOR BACKGROUND SIGNAL CANCELLATION IN AN OPTICAL PICKUP**

(57)    An optical sensor circuit for improved background signal cancellation in a musical instrument pickup. An operational amplifier is configured as a transimpedance amplifier (TIA). The TIA is electrically coupled to a first photodetector and a second photodetector in a series connection wherein the anode of the first photodetector and the cathode of the second photodetector are electrically coupled to define a connection node that is electrically coupled to an input of the TIA. In this configuration, symmetric in-band and out-of-band background optical signals and symmetric DC signals received by the pickup are negated. Asymmetric non-DC signals that are output from the photodetectors are passed to the input of the TIA as a signal of interest generated at the connection node.

FIG.5

EP 4 704 337 A1

**Description**

BACKGROUND OF THE INVENTION

Electronic circuitry comprising one or more photodetector elements configured for the detection of optical signals is commonplace and has numerous applications in a variety of sensor systems including optical guitar pickup systems. Photodetectors in optical detection systems are typically configured to receive an optical input signal within the optical bandwidth of the sensor and generate an electrical output that is proportional to the power of the input signal. The electrical output of the photodetectors may then be received as an input by subsequent circuitry for further processing or signal conditioning, depending on the user-defined application.

A significant challenge in the design of photodetector circuitry is minimizing the effects of undesired ambient or background optical energy that is within the bandwidth of the photodetectors. Background optical energy detrimentally acts as an additional optical input to the system's photodetectors and combines with the desired input signal. This results in an electrical input to subsequent circuitry that is not representative of the desired input signal of interest. Background optical energy is generally not of interest in an optical sensing system when summed with the desired input signals in an optical detection system. This is because the received in-band background optical energy interferes with the accurate detection of the input signals, in turn adversely affecting the output of the system.

The term "photodetector" as used herein may describe a single element or a multi-element photodetector component, a plurality of photodetector components, or an array of photodetector components. Suitable photodetectors for use in the invention may comprise any photosensitive technologies responsive to the optical portion of the electromagnetic spectrum such as phototransducers, photoconductors, light dependent resistors (LDR), photothyristors, photodarlington transistors and phototransistors. A photodetector as used herein may comprise any device or component that is capable of generating a varying electrical signal in response to the impact and/or absorption of photons.

SUMMARY OF THE INVENTION

The present invention relates to the accurate detection of optical input signals of interest as inputs to an optical sensing system, such as an optical guitar pickup system, in the presence of undesirable background optical energy.

More particularly, the device and method of the invention relate to circuitry comprising a plurality of in-series photodetector elements electrically coupled to, for instance, an operational amplifier (op-amp) that may be configured as a transimpedance amplifier (TIA) for the suppression or cancellation of undesired in-band background optical energy that is incident upon the photodetector elements of the system.

The invention herein has particular utility when applied to optical systems where the relative optical power of the background optical energy is large with respect to the optical power of the desired input signals that are within the optical bandwidth of detection. This is often the case where the bandwidth of detection is wide and involves numerous in-band optical signals at wavelengths that are different from the desired in-band input signal wavelength, or where significant background optical energy exists at or near the desired detection wavelength.

The invention is useful in systems where tight bandpass optical filtering is not practical because the desired input signals exist over a range of in-band wavelengths, or the input signals are incident upon the photodetectors at angles that render tight optical filtering difficult or impractical for the intended application.

The invention has beneficial application in circuitry where the detection of the optical signal undesirably permits a large amount of unwanted background optical energy to couple with a desired input signal. This may occur in low modulation depth optical detection applications such as an optical musical instrument pickup where the desired input signal is present at a time or position or both, that is different from the background optical energy.

A non-limiting example of a low optical modulation depth detection application is the detection of a string vibration of a stringed musical instrument such as a guitar as disclosed in U.S. Patent No. 10,878,790, issued December 29, 2020, to Geske et al., the entirety of which is incorporated herein by reference (also referred to as the "'790 patent" herein). The method and device of the instant invention improves the modulation depth of an optical input signal in circuitry used for the detection of amplitude modulated (AM) optical signals for converting a musical instrument string vibration into an electrical signal.

A further non-limiting application of the invention may comprise circuitry wherein a plurality of electrically coupled photodetector elements exist in varying positions with respect to each other, including being adjacent to each other, or instances where a plurality of photodetectors in a system are separated by optically significant distances.

Additional application areas of the invention include free space optical communications, laser warning systems including ground-based, vehicle-based and body-worn systems, as well as the conversion of stringed musical instrument vibrations into electrical signals.

For purposes of clarity, the following terms have the following definitions as used herein.

"Optical bandwidth" as used herein refers to the optical wavelengths to which a photodetector element or plurality of photodetector elements is optically responsive. Multiple connected photodetector elements may be incorporated in the invention having the same effective bandwidth, overlapping bandwidth ranges, or non-overlapping bandwidth ranges varying by application.

"Electrical bandwidth" as used herein refers to the frequency range to which an electronic circuit or system can receive or is responsive to.

"DC electrical signal" as used herein refers to an electrical signal that is varying at a rate so as to fall within the lower frequency range of acceptable electrical bandwidth of subsequent circuits in an optical system. DC electrical signals may be within the electrical bandwidth of such circuits or out of the electrical bandwidth, depending upon circuit design.

"DC optical signal" or "DC signal" as used herein refers to an optical signal for which a detection generates an electrical signal falling within the definition of the above DC electrical signal.

"In-band signal" as used herein refers to an optical signal for which a detection generates an electrical signal that is within the acceptable electrical bandwidth of the respective photodetector and subsequent electronic circuits in an optical detection system.

"Out-of-band signal" as used herein refers to an optical signal for which a detection generates an electrical signal that is not within the acceptable electrical bandwidth of the respective photodetector and/or the subsequent electronic circuits in an optical detection system. An out-of-band signal may be attenuated by the circuit design of the related system or designed to bypass the primary detection circuits. An out-of-band signal may be lower or higher than the acceptable frequency range of function of the subsequent circuitry in an optical detection system.

"Primary detection circuit" as used herein refers to electronic circuitry used in detecting an in-band optical signal. A primary detection circuit may comprise transimpedance amplifiers, attenuators, comparators, analog circuits, digital circuits, voltage amplifiers, DC-blocking capacitors and filters, bias resistors, active filters, passive filters, modulators, product multipliers or demodulators, analog-to-digital convertors (ADC), indicators, and signal conditioning, storage or transmitting elements.

"Bandpass" as used herein refers to a wavelength range for which a photodetection filter is applied to permit a received optical signal to pass to the next element in an optical beam path.

"Background signal" as used herein may variously be referred to as "background optical energy", "background optical signal" or "Obkgnd" and refers to a received optical signal or portion thereof that does not carry wanted information.

"Optical signal of interest" as used herein may variously be referred to as "input signal" or "Osig" and refers to a received optical signal or portion thereof that carries wanted information, and which may be detrimentally impacted by the presence of a background optical signal.

"Photodetector" as used herein may comprise a light sensitive component that by the nature of its material properties, produces or modifies electrical signals when the device absorbs or interacts with photons. Examples may include photodetectors that are PN, PIN, or avalanche, photoconductors, metal-semiconductor-metal (MSM), and Schottky diode structures.

"Transimpedance" as used herein means the conversion of an electrical signal from a current to a voltage signal or vice versa. Transimpedance or transconductance is desirable where a photodetector produces either a current or voltage signal and the amplification or the processing circuit needs the other. In certain of the non-limiting examples set forth herein, reverse biased PIN photodetectors are used which produce a current. The current may be converted using circuit means such op-amp circuitry in a transimpedance amplifier configuration to produce proportional voltage signals used by subsequent circuit elements of the system.

"Gain" as used herein refers to the ability of a circuit to modify an input signal strength or amplitude. Gain may be positive or negative. Though gain typically refers to amplification of a signal, gain may be less than unity. A gain that is less than unity may be referred to as attenuation.

"Light" as used herein refers to the optical portion of the electromagnetic spectrum and embraces not only the visible spectrum that is detectable by the human eye but may include other regions of the electromagnetic regions relevant to optoelectronics in the ultraviolet and infrared spectrum.

"Negating" as used herein refers to an instance where one electrical signal is partially or entirely canceled by another signal. Prior art examples of negating a signal include electronic means for adding or subtracting voltage signals after a TIA to allow a background optical signal to be canceled by a nearly equal and opposite optical signal with respect to a common mode voltage which may be implemented before or after processing electronics.

Signal negation may be accomplished by allowing a background optical signal to be nearly equally generated by a pair of photodetectors in a set of series-connected photodetectors and whereby the background optical signal passes through both photodetector elements and is diverted or prevented from entering the primary detection circuits. This process occurs with both voltage generating photodetectors and current generating photodetectors. Current generating detectors will be described in this invention background description, but it is expressly noted the invention is not limited to such elements and may comprise any suitable voltage-generating or current-generating photodetector element.

The invention does not preclude means or methods for measuring the magnitude of negated signals. Rather, in-band signals produced by the detection of background optical signals are negated such that they do not continue to the primary detection circuitry where they may impair the ability of the detection circuitry to accurately measure and act upon the portion of the desired in-band signal produced by the received optical signal.

In a first aspect of the invention, an optical sensor circuit having improved background signal cancellation is provided comprising a first photodetector that comprises a first anode and a second photodetector that comprises a second cathode.

The first photodetector and the second photodetector are connected in series by means of electrically coupling the first anode to the second cathode to define a connection node. Circuit means, such as an operational amplifier configured as a transimpedance amplifier (TIA), is provided comprising an op-amp input.

The connection node is electrically coupled to a predetermined low impedance reference voltage which may comprise a circuit ground by means of a bias resistor. The connection node and the input of the TIA are electrically coupled by means of a DC-blocking capacitor. The circuit further comprises one or more power supply sources configured to maintain proper bias on the first photodetectors and second photodetectors.

The invention further comprises electronic circuitry whereby an electrical signal representative of a difference in an optical signal received by the first photodetector and the second photodetector is generated at the connection node.

In a second aspect of the invention, the first photodetector may be responsive to a first range of optical wavelengths and the second photodetector may be responsive to a second range of optical wavelengths. The first photodetector may comprise a silicon (Si) photodetector and the second photodetector may comprise an indium gallium arsenide (InGaAs) photodetector.

In a third aspect, the invention may comprise a light emitting source comprising a light output incident on the first photodetector and the second photodetector. The light output may comprise a modulated output. The light output from the light emitting source may comprise a modulated source such as a sine wave or square wave. The electrical signal at the op-amp input may comprise an "amplitude modulated" signal. One or more of the photodetectors may comprise a tapered light collection surface or lens or may comprise a user-defined lens or light receiving surface.

In a fourth aspect, the invention may be configured in a reflective mode embodiment wherein the light received by the photodetectors varies in proportion to a reflection of the modulated output received from the surface of a vibrating string of a musical instrument.

In a fifth aspect, the invention elements may be configured in a transmissive mode embodiment wherein the light received by the photodetectors varies in proportion to an optical interference or varying optical power of the light resulting from a vibrating string of a musical instrument.

In a sixth aspect, the invention may be provided as a plurality of subassemblies in the form of a multi-bank optical sensor circuit.

In a seventh aspect, the invention may further comprise voltage swing direction detection circuitry configured whereby a voltage swing at the connection node is used to determine which photodetector or bank of photodetectors receives an optical signal having one or more user-defined optical characteristics.

In an eighth aspect, the invention may comprise a first photodetector having a first low voltage side connection and a second photodetector having a second high voltage side connection. The first photodetector and the second photodetector are connected in series by means of electrically coupling the first low voltage side connection to the second high voltage side connection to define a connection node. The connection node is electrically coupled to a predetermined low impedance reference voltage by means of a bias resistor. The connection node and the input are electrically coupled by means of a DC-blocking capacitor. Bias means is provided to maintain a first bias on the first photodetector and a second bias on the second photodetector, and circuit means is provided whereby an electrical signal representative of a difference in an optical signal received by the first photodetector and the second photodetector is generated at the connection node.

These and various additional aspects, embodiments and advantages of the present invention will become apparent to those of ordinary skill in the art upon review of the Detailed Description and any claims to follow herein.

While the claimed apparatus and method herein has or will be described for the sake of grammatical fluidity with functional explanations, it is to be understood that the claims, unless expressly formulated under 35 USC 112, are not to be construed as necessarily limited in any way by the construction of "means" or "steps" limitations, but are to be accorded the full scope of the meaning and equivalents of the definition provided by the claims under the judicial doctrine of equivalents, and in the case where the claims are expressly formulated under 35 USC 112, are to be accorded full statutory equivalents under 35 USC 112.

BRIEF DESCRIPTION OF DRAWINGS

Fig. 1A is a schematic of a prior art photodetector circuit.

Fig. 1B is a graph of the optical input signal pulse Osig that is detected and output as Vsig by the photodetector circuit of Fig. 1A.

Fig. 2A is the circuit of the prior art photodetector circuit of Fig. 1A depicting operation in a real-world environment.

Fig. 2B is a graph depicting the optical power of the prior art photodetector circuit of Fig. 2A in a condition where signal clipping is induced due to unwanted in-band background optical signals.

Fig. 3A, shows a schematic of a further prior art photodetector circuit for the suppression or cancellation of unwanted in-band background optical signals.

Fig. 3B is a graph illustrating the TIA output resulting from the summing of background optical signal Obkgnd and the desired input optical signal Osig of the photodetector circuit of Fig. 3A.

Fig. 3C is a representative illustration of the in-band portions of the background optical signal Obkgnd and the optical input signal Osig and shows that the Vsig output of the TIA of Fig. 3A is an unwanted combination of the amplified Idet current generated from the two signals.

Fig. 4A is a further prior art circuit which amplifies input optical signals Osig and background optical signals Obkgnd and outputs a positive-going voltage pulse.

Fig. 4B shows the output of the circuit of Fig. $A followed by the output of the circuit of Fig. 3A and the result if the output signals of the two detection circuits are added.

Fig. 5 is a schematic of a preferred embodiment of the circuit of the invention showing a pair of series-connected photodetectors.

Fig. 6A and Fig. 6B are top and side views of an exemplar LED and photodetector layout for a reflected light mode optical pickup configuration on a stringed musical instrument.

Fig. 7 depicts an exemplar six-string reflected light configuration for an optical pickup on a stringed musical instrument.

Fig. 8A and Fig. 8B are top and side views of an exemplar transmissive light mode configuration on a stringed musical instrument.

Fig. 9 shows a block diagram of a preferred embodiment of an optical pickup system of the invention on a single string of a musical instrument.

Fig. 10A, Fig. 10B and Fig. 10C show a top, side and face view of an alternative physical layout comprising the circuit of the invention.

Fig. 11A depicts an exemplar operating condition for a laser detection system for the negation of solar background energy for sensing a 1550 nm laser pulse.

Fig. 11B is a graph showing the respective Osig and Obgnd signals incident upon a first silicon photodetector and a second InGaAs photodetector in a preferred embodiment of the invention and the related output in the case of a 1550 nm laser pulse.

Fig. 12A depicts a further exemplar operating condition for a laser detection system for the negation of solar background energy for sensing a 905 nm laser pulse.

Fig. 12B is a graph showing the respective Osig and Obgnd signals incident upon a first silicon photodetector and a second InGaAs photodetector in a preferred embodiment of the invention and the related output in the case of a 905 nm laser pulse.

Fig. 13 is a preferred embodiment of a system architecture of a laser warning system for enabling the circuits of Fig. 11A and 12A.

Fig. 14 is a schematic of an alternative embodiment of the circuit of the invention incorporating a pair of series-connected light dependent resistor elements (LDRs) comprising a respective lower voltage side connection and higher voltage side connection.

Fig. 15 is a schematic of an alternative embodiment of the circuit of the invention incorporating a pair of series-connected phototransistor elements comprising a respective lower voltage side connection and higher voltage side connection.

The invention and its various embodiments can now be better understood by turning to the following Detailed Description of the preferred embodiments which are presented as illustrated examples of the invention in any subsequent claims in any application claiming priority to this application. It is expressly understood that the invention as defined by such claims may be broader than the illustrated embodiments described below.

DETAILED DESCRIPTION OF THE INVENTION

Various embodiments and aspects of the invention are described with reference to details discussed below and the accompanying drawings illustrating certain of the various embodiments. The following description and drawings are illustrative of the invention and are not to be construed as limiting the invention. Numerous specific details are described to provide a thorough understanding of various embodiments of the present invention. However, in certain instances, well-known or conventional details are not described in order to provide a concise discussion of certain of the embodiments of the present invention.

Reference in the specification to "one embodiment", "an embodiment" or "some embodiments" means that a particular feature, structure, or characteristic described in conjunction with the embodiment can be included in at least one embodiment of the invention. The appearances of the phrase "in one embodiment" in various places in the specification do not necessarily all refer to the same embodiment.

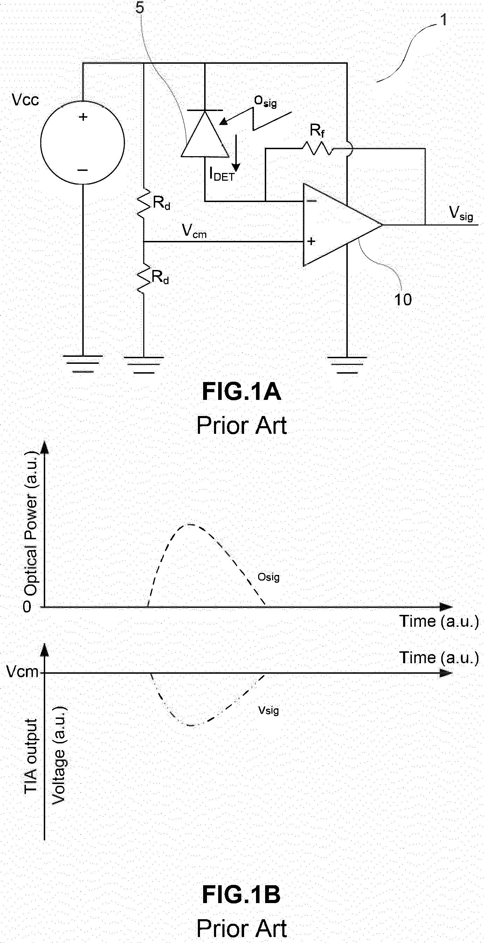

Turning now to the figures, Fig. 1A is a schematic of a prior art circuit 1 for the suppression or cancellation of unwanted in-band background optical signals in an optical sensing system. This circuit makes use of a photodetector 5 and circuit means such as an op-amp 10 configured as a transimpedance amplifier (TIA).

Transimpedance amplifiers function as current-to-voltage converters and are well-suited for use in photodetector systems since photodetectors tend to have a more linear current response to an input than a voltage response. Further, a transimpedance amplifier is a low impedance circuit and beneficially isolates the photodetector from the output voltage of the operational amplifier.

In the prior art circuit 1 of Fig. 1A, a photodetector output current (Idet) is generated in response to the absorption of an optical signal Osig by means of, in this instance, a PIN photodetector 5. This illustration assumes the optical input Osig is ideal and there is no unwanted background optical signal.

The output current Idet generated by PIN photodetector 5 in response to Osig is amplified by the TIA and generates a voltage Vsig that is -Rf multiplied by the current Idet from photodetector 5. Vsig is referenced to the common mode voltage, Vcm, and swings lower in voltage than Vcm as a result of the transimpedance amplification of Idet.

In the illustrated prior art device 1, the lower limit of Vsig is approximately the lower end of the specified output voltage drive capacity of op-amp 10. In certain op-amps, this may be the lower bias limit of the op-amp and is approximately at ground potential in the illustrated example which illustrates a rail-to-rail output capable op-amp.

Circuit ground in the prior art circuit 1 of Fig. 1A has a potential of about -0- volts. It is noted the circuit of the instant invention is not limited to ground-referenced amplifiers or single supply op-amps and that the circuit of the invention may be configured for use with single supply-biased op-amps that are capable of rail-to-rail output swings from a negative voltage rail to a positive voltage rail of the device.

Fig. 1B depicts a graph of the optical input signal pulse Osig that is detected by photodetector 5 of Fig. 1A along with the electrical pulse output produced by the associated TIA circuitry.

In the case of PIN photodetector 5, when an input optical signal Osig is within the bandwidth of photodetector 5 and is incident upon it, photodetector 5 generates a current Idet that is proportional to the optical signal strength absorbed by it. In instances where Osig comprises an in-band signal, the TIA produces an amplified voltage pulse whose magnitude is the product of - Rf multiplied by Idet current pulse strength when Idet is within the bandwidth of the TIA.

Unfortunately, the output waveform of the prior art circuit 1 of Fig. 1A is subject to system frequency response limitations and thus its shape may be undesirably altered by the detection and amplification process (here waveform shape modifications are neglected as it is assumed Osig is an in-band signal).

This detection means is used in many optical detection systems including fiber optical communications, LIDAR, LADAR, free space optical communications, laser warning systems, optical pickups, and other optical applications.

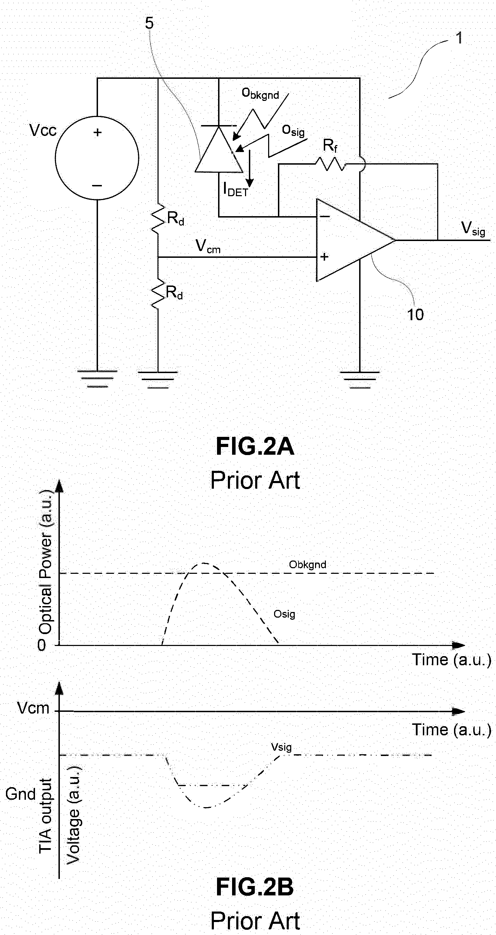

Fig. 2A is the schematic of the prior art circuit 1 of Fig. 1A but depicts the optical detection circuit of Fig. 1A in a real-world environment where the detection of in-band signals is made up of both undesired in-band background optical signals Obkgnd and desired in-band optical input signals Osig. In real world operating environments, background optical signals Obkgnd are often present and within the bandwidth of photodetector 5. Near-steady sunlight is an example of such a background optical signal with respect to the prior art circuit 1 depicted in Fig. 2A. These background signals Obkgnd are detected and amplified along with the desired Osig and contribute to the Idet current signal from photodetector 5.

Fig. 2B is a graph depicting the optical power resulting from the combined in-band signals of input optical signal Osig and background optical signal Obkgnd in prior art circuit 1, in a case where signal clipping is induced as the result of the TIA gain being applied to both signals. The presence of Obkgnd makes the detection and processing of the desired input optical signal Osig difficult in that it masks or modifies the shape, strength, frequency content and/or other attributes of the desired in-band optical signal.

The background optical signal Obkgnd may also consume a portion of the output dynamic range of the TIA and cause the desired optical signal to be clipped. Fig. 2B shows the simultaneous detection of the background signal Obkgnd and the input optical signal Osig and illustrates how the output of the TIA is clipped due to the presence of background signal Obkgnd. In the illustration of Fig. 2B, the background optical signal Obkgnd is an in-band optical signal with a slowly varying nature.

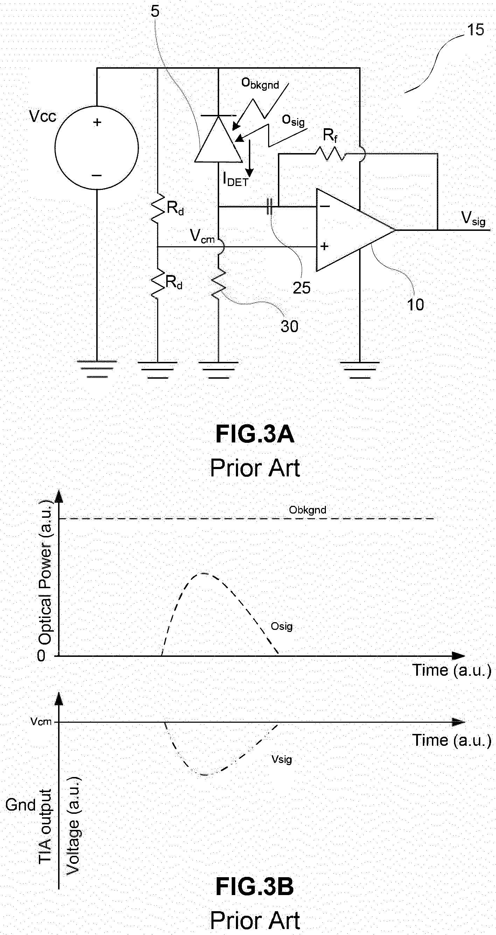

Fig. 3A is a schematic of a further prior art circuit 15 for the suppression or cancellation of unwanted in-band background optical signals in an optical sensing system intended to mitigate the effects of background optical signals Obkgnd that are slowly varying (e.g., a DC optical signal) with respect to a desired input optical signal Osig.

The prior art circuit 15 further comprises a DC-blocking capacitor Cblock 25 and a bias resistor Rbias 30 that may be implemented in environments where the background optical signal Obkgnd comprises a DC optical signal. A DC optical signal undesirably causes the Idet resulting from the background optical signal Obkgnd to take a path through Rbias 30 of the circuit rather than through the TIA.

DC-blocking capacitor Cblock 25 in the prior art circuit 15 of Fig. 3A is referred to as a DC-blocking capacitor in that it blocks DC electrical signals from entering subsequent circuit elements of the optical system itself. DC-blocking capacitor Cblock 25 blocks DC electrical signals produced by the background optical signals Obkgnd. Series DC-blocking capacitor Cblock 25 in the prior art circuit of Fig. 3A may be also referred to as an AC-coupling capacitor and functions to remove DC or near-DC electrical signals from the bandwidth of the primary detection circuits. In this manner, DC electrical signals become out-of-band signals.

In conditions where the background optical signal Obkgnd is slowly varying as may occur in sunlit environments, its detection produces a DC electrical signal from photodetector 5. The use of DC-blocking capacitor Cblock 25 and bias resistor Rbias 30 provides an alternate path for the current generated by the portion of the background optical signal Obkgnd that undesirably contributes to Idet. In this prior art approach, the Idet current resulting from Obkgnd is conducted through Rbias 30 to ground as shown in Fig. 3A and does not pass to the input of the TIA.

Bias resistor Rbias 30 in the embodiment of Figure 3A is added to maintain a predetermined reverse bias on photodetector 5 in order to maintain the photodetector's desired frequency response. Without bias resistor Rbias 30, there is no controlled reverse bias on photodetector 5 and its performance slows due to poor current transmission and frequency response as is typical of unbiased PIN detectors. The DC electrical signals beneficially pass through Rbias 30 as the lowest impedance path to the lower potential (shown as ground in the circuit of Fig. 3A).

Fig. 3B is a graph that depicts the background optical signal Obkgnd and the desired input optical signal Osig. Fig. 3B depicts a frequency content difference between the two signals that is leveraged by the circuit of Fig. 3A to block the background optical signal Obkgnd. Fig. 3B shows that despite the relatively large magnitude of the background optical signal Obkgnd, the Vsig output of the TIA is not significantly impacted.

Despite the presence of Obkgnd that is larger in peak magnitude than the peak magnitude of the optical input signal, Osig, the TIA outputs a Vsig that is primarily derived from and is representative of Osig.

The selection of Rbias 30, Cblock 25, and the TIA input impedance of the circuit of Fig. 3A dictate the characteristics of the signals that will be considered DC optical signals for a given optical detection system.

The prior art approach of Fig. 3A has numerous deficiencies. Operating conditions may exist where background signal Obkgnd is so large that the current through Rbias 30 causes a voltage drop sufficient to "debias" photodetector 5 and degrade the performance of the system. This degradation is caused by a multitude of electronic interactions and the overall impact of the loss of bias is specific to the selected photodetector.

In the case of a PIN photodetector, when the reduction of reverse bias does not exceed the total reverse bias, the reduction of reverse bias tends to increase capacitance, which in turn slows the frequency response of the circuit and increases the noise of the circuit. Moreover, when the reduction of reverse bias approaches the total reverse bias, photodetector 5 functionally becomes a forward biased diode and any detected signals cannot readily be output from the circuit.

DC-blocking capacitor Cblock 25 of the prior art circuit of Fig. 3A assists in minimizing the negative effects of background optical signals Obkgnd but has limitations beyond the potential debiasing of photodetector 5. If background optical signal Obkgnd produces or comprises an in-band signal, Obkgnd passes through the DC-blocking capacitor Cblock 25 into the primary detection circuitry with input signal Osig where both are amplified as in-band signals. The output of the TIA becomes a voltage signal that is the amplified sum of the photodetector 5 current Idet resulting from the detection of the optical signal Osig and the background optical signal Obkgnd.

In such a case, if background optical signal Obkgnd is sufficiently strong, the output of the TIA becomes saturated, i.e., driven to the highest output voltage limit of the TIA. Thus, the prior art approach of Fig. 3A does not completely obviate the detrimental effects of background optical signals Obkgnd that are within the bandwidth of photodetector 5.

This condition is partially addressed by the teachings of the '790 patent which discloses a means for the elimination of a significant portion of the unwanted in-band amplified Vsig that is generated by the TIA. This is achieved by use of a frequency multiplier circuit for conditions where the optical input signal Osig is an amplitude modulated (AM) optical signal frequency and the background optical signal Obkgnd is not at the identical frequency via the incorporation of a product multiplier.

Nonetheless, conditions may exist where the background optical signal Obkgnd is sufficiently strong that the current generated from its detection degrades the reverse bias on photodetector 5. Further, the background optical signal Obkgnd may be an in-band signal and may be great enough to cause the output of the TIA to reach its maximum voltage swing capacity or exceed its slew rate capacity, resulting in amplification of a signal that is not representative of the desired optical input Osig.

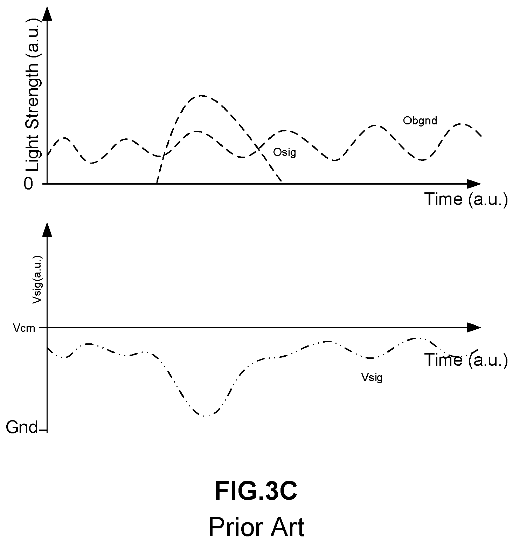

Fig. 3C is a representative illustration of the in-band portions of the background optical signal Obkgnd and the optical input signal Osig and shows the Vsig output of the TIA is an unwanted combination of the amplified Idet current generated from the two signals. The detection of background optical signal Obkgnd produces an in-band signal that appears at the output of the TIA combined with the amplified input optical signal Osig.

The teaching of U.S. Pat. No. 10,878,790 may be incorporated as a means to minimize in-band optical background signals so long as the signals do not cause the TIA to exceed its output slew rate or voltage swing capability or cause the photodetector to debias.

This approach is best incorporated for use in systems where one or more product multiplier circuits are used and the optical input signal Osig is an amplitude modulated (AM) optical signal frequency used to negate the portions of the background optical signals Obkgnd that are not at the identical Osig frequency. If all of these conditions are not met, the signal content of the desired optical signal is lost, and the techniques taught in U.S. Pat. No. 10,878,790 are inapplicable. The device and method taught in the '790 patent uses product multipliers to remove signals that are not near the local oscillator frequency using known techniques of amplitude modulation and baseband recovery.

Additional prior art means for reducing unwanted background optical signals includes the use of the secondary circuits of U.S. Pat. No. 10,878,790, such as the product multipliers of the '790 patent, as well as optical bandpass filtering, detection wavelength selection, or system-specific mechanical arrangement. All of the above are applicable to very specific cases and may be designed to meet predetermined system requirements.

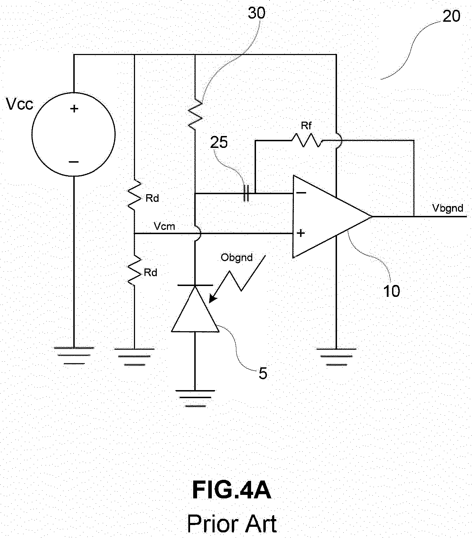

The disclosure of U.S. Pat. No. 10,878,790 further teaches the use of a second detection channel that is effectively subtracted from the first detection channel so that any background optical signals Obkgnd that are common between the two channels are negated. The teachings of U.S. Pat. No. 10,878,790 may be used to produce an input signal Osig where the background optical signal Obkgnd is minimized or removed, either by signal subtraction or by inversion and addition. Fig. 4A depicts a prior art circuit 20 that, much like the circuit of Fig. 3A, amplifies input optical signals Osig and background optical signals Obkgnd, but instead of outputting a negative-going voltage pulse from the TIA, the circuit outputs a positive-going voltage pulse.

This circuit illustrates a secondary or alternate circuit configuration that can be used to produce an opposite-going pulse from a background optical signal Obkgnd. In certain system configurations, such a circuit collects the nearly identical optical background signal Obgnd, which signal is then added to the TIA output of the detection circuit of Fig. 4A to enable a moderate level of background optical signal Obkgnd negation.

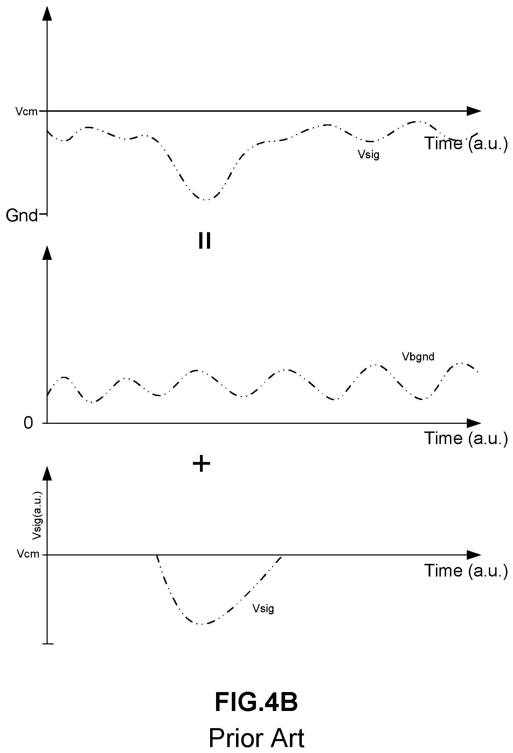

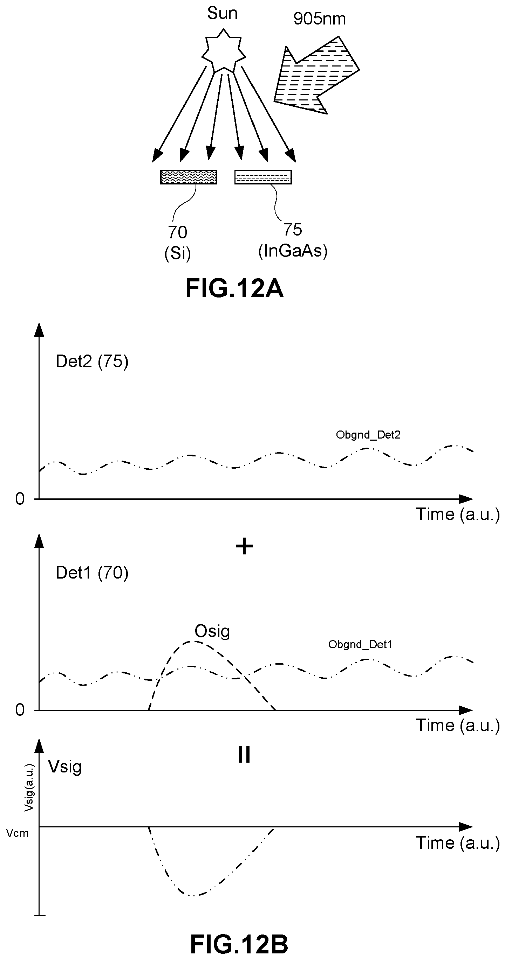

Figure 4B illustrates the output of the circuit of Fig. 3A followed by the output of the circuit of Fig. 4A and the result where the two signals are added as taught in the '790 patent. A secondary detection circuit can be used to detect comparable background signals Obkgnd. The circuit may be identical to the circuit of Fig. 3A and further comprise the circuit taught in Fig. 12 of U.S. Pat. No. 10,878,790, inclusive of processing elements that may comprise a signal inverting circuit and a signal adding circuit or a signal subtraction circuit.

In the alternative, a similar approach can be of the embodiment shown in Fig. 4A and produce a positive-going electrical pulse rather than a negative-going electrical pulse. The signals of Fig. 3A and Fig. 4A can be added. Any of the above subtraction, inversion, or addition approaches will result in the background signal Obkgnd largely eliminated.

In an alternative embodiment, it is possible to attenuate the strength of Obkgnd signal in the secondary circuitry by means of optical filtering, detection wavelength selection, or mechanical arrangement such that the subsequent summing of the Osig and Obkgnd signals negates the effect of the background optical signal Obkgnd.

The foregoing descriptions of the prior art show the use of the DC-blocking capacitor Cblock 25 and the methods taught in U.S. Pat. No. 10,878,790. The secondary circuit approach has the benefit of removing background signals Obkgnd that are in-band of the primary detection circuit. When used with DC-blocking, this approach seeks to address the need for blocking in-band and out-of-band background optical signals.

Nonetheless, the secondary circuit approach has a significant limitation. In the event the background optical signal Obkgnd is strong, Obkgnd can saturate the output of the primary detection circuits in signal swing or slew rate and this approach does not prevent the potential for debiasing of the photodetectors.

This limits the peak gain that can be used in the transimpedance amplifier. The circuit gain must be limited to prevent output saturation of the amplifier for either the optical signal Osig or the background signal Obkgnd.

It is desirable that circuit gain be selected for optimal optical signal amplification but not limited by the presence of the background optical signals Obkgnd. Thus, a circuit would ideally negate the signal produced by the detection of the background optical signal Obkgnd before it reaches the primary detection circuits.

The use of a DC-blocking capacitor is similarly limiting in that the selection of Cblock 25 and Rbias 30 are limited by the amount of background optical signal Obkgnd. The background optical signal Obkgnd serves to debias the photodetector. Ideally, a large Rbias 30 is preferrable with the input impedance of the transimpedance amplifier so that the current Idet generated from the majority of the desired optical signal Osig is passed into the amplifier and not to the bias resistor.

This is not the case here however, because a large bias resistor Rbias 30 can result in the debiasing of the photodetector. Thus, a designer is forced to select an Rbias 30 resistance value that is low enough to avoid debiasing under expected operating conditions. Such conditions may include very bright sunlight and thus this limitation can be severe.

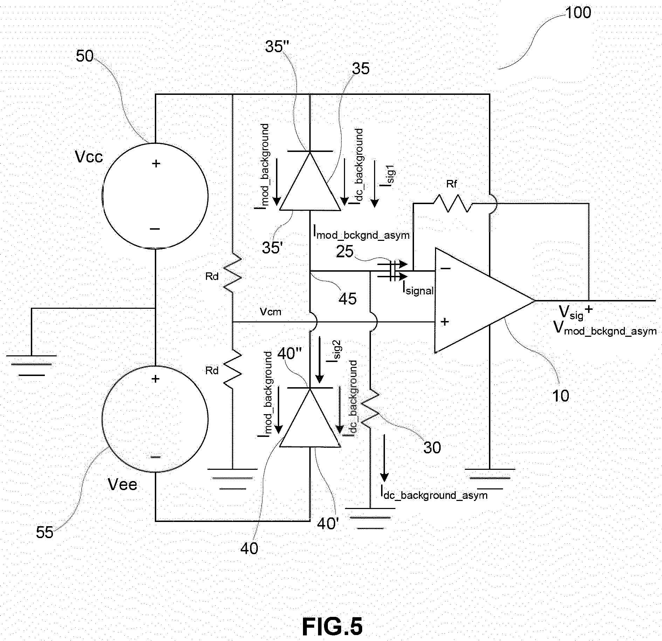

Fig. 5 illustrates a preferred embodiment of the present invention 100. The circuit of Fig. 5 implements a pair of series-connected first photodetector 35 and second photodetector 40, allowing for any optical input signal common between first and second photodetectors 35 and 40 to be negated and to bypass the primary detection circuits and bias resistor Rbias 30.

The optical circuit 100 of Fig. 5 may comprise an operational amplifier 10 configured as transimpedance amplifier with a non-inverting (+) input, an inverting (-) input and an output.

A first photodetector 35 is provided comprising a first anode 35' and a first cathode 35'' in series connection with a second photodetector 40 comprising a second anode 40' and a second cathode 40''. First anode 35' is electrically coupled to the second cathode 40'' to define a connection node 45. Bias resistor Rbias 30 is electrically coupled and disposed between connection node 45 and a predetermined low impedance reference voltage which may comprise a circuit ground. DC-blocking capacitor Cblock 25 is electrically coupled between connection node 45 and the inverting (-) input of the op-amp 10.

The system further comprises first bias means as a first power supply 50 comprising a first positive output electrically coupled to first cathode 35'' and a first negative output electrically coupled to the predetermined low impedance reference voltage which may comprise a circuit ground, whereby a predetermined first bias is maintained on first photodetector 35.

The system further comprises a second bias means as a second power supply 55 comprising a second positive output electrically coupled to the predetermined low impedance reference voltage which may comprise a circuit ground and a second negative output electrically coupled to second anode 40', whereby a predetermined second bias is maintained on second photodetector 40.

Electrically coupled, series-connected first photodetector 35 and second photodetector 40 are configured such that the electrical signal used by the primary detection circuit is taken from connection node 45 that exists between first anode 35' of first photodetector 35 and second cathode 40'' of second photodetector 40.

In this configuration, any symmetric in-band background optical signal and any symmetric out-of-band background optical signal pass through both first photodetector 35 and second photodetector 40 and dissipate to ground (or any user-defined low impedance reference). Any symmetric out-of-band background signals that are DC signals bypass bias resistor Rbias 30 and thus prevent loss of photodetector reverse bias. Any symmetric in-band background signals bypass the TIA, thus preventing amplifier output saturation.

Rbias 30 may comprise any circuit element capable of providing a controlled impedance path to the reference voltage which may comprise a circuit ground in certain configurations. In printed circuit board technology, the controlled impedance path may comprise a surface mount or through-hole resistor. In integrated circuitry, resistors are more difficult to implement, and a transistor may be used to implement the controlled impedance function. For very high frequency in-band signals near and above 1 MHz, Rbias 30 may be implemented by means of a ferrite bead or equivalent element.

The function of Rbias 30 is to bias the photodetectors so that current flows when light is incident upon them as well as provide a controlled low impedance path for the out-of-band signals to the reference voltage, particularly the signals blocked by DC-blocking capacitor Cblock 25.

The reference voltage is shown in Fig. 3A and Fig. 5 as the ground supply connection and is shown as the Vcc connection in Fig. 4A. In Fig. 5, the low impedance reference voltage to which Rbias 30 is connected is shown as a common connection ground.

The purpose of this connection is to provide a low impedance and stable reference voltage that has the appropriate voltage offset from the voltage that is connected to the other bias connection of the photodetector in order to provide a bias voltage to the photodetector.

For Fig. 3A, a voltage lower than Vcc is desired, so the common connection ground is a preferred choice. For Fig. 4A, a voltage larger than the common connection ground is desired so Vcc may be used.

In this invention, the two series-connected photodetectors element exist between a higher voltage Vcc and a lower Vee with an Rbias 30 connection at connection node 45 electrically coupled to the reference voltage.

As is illustrated in Fig. 5, first photodetector 35 comprises a first low voltage side connection and second photodetector 40 comprises a second high voltage side connection. Each are connected in series by means of electrically coupling the first low voltage side connection to the second high voltage side connection to define connection node 45. Connection node 45 is electrically coupled to a predetermined low impedance reference voltage, here illustrated as a circuit ground by means of bias resistor Rbias 30.

If the photodetector elements are PIN detectors, connection node 45 may comprise the respective anode of the higher voltage device and the respective cathode of the lower voltage device.

The symmetry of the optical collection of first and second photodetectors 35 and 40 is maintained so that the remaining asymmetric in-band background signals and asymmetric out-of-band background signals are low and are managed within the system design and dynamic range of the associated electronics.

The invention avoids the prior art constraints placed on the selection of Rbias 30 and gain limitations of the primary detection circuits that are imposed by the magnitude of the background optical signal.

System 100 of Fig. 5 provides that any remaining asymmetric signals that are not DC signals desirably pass to the TIA and asymmetric DC signals pass to ground via bias resistor Rbias 30. In the non-limiting illustrated embodiment of Fig. 5, desired optical signals can be present on one or both of the first and second photodetectors 35 and 40.

If the signals are not presented at the same time, the circuit detects and amplifies each of them. In this instance, first photodetector 35 produces a negative-going signal with respect to common mode voltage (Vcm) and second photodetector 40 produces a positive-going signal with respect to Vcm. Processing electronic circuit means are provided for the differentiation of the signals between them.

Here, Vsig= -Rf*(Idet1-Idet2) for in-band optical signals. Idet = R * Poptical (R: PIN detector responsivity A/W) (similar equations exist in the prior art for other types of photodetectors).

In an embodiment of system 100 in a laser warning system, first photodetector 35 may be provided as an InGaAs photodetector having, for instance, a 1-1.7 $\mu$um sensitivity and second photodetector 40 may comprise a silicon photodetector having, for instance, a 0.4-1 $\mu$m sensitivity. First and second photodetectors 35 and 40 may be specified so that a typical sunlight spectrum produces an approximately symmetric response. A positive-going and negative-going comparator following the TIA may be incorporated in order to detect in-band signals on either the InGaAs or the silicon photodetector.

In this manner, any photodetector bias loss due to, for instance, high solar optical background signals, is avoided. The optical detection of signals in both the silicon band and the InGaAs band is accomplished and distinguished from each other with a single transimpedance amplifier. TIAs responsive to laser detection frequency bandwidths may consume hundreds of milliwatts, so the invention herein enables significant reductions in power consumption, part count, and space needed.

In one embodiment of the system 100 of Fig. 5 comprising a circuit configured for use as an optical pickup for stringed instruments, a large carrier frequency-modulated LED signal is typically present at first photodetector 35 and second photodetector 40 because the string reflects modulated LED light into both photodetectors simultaneously. The string vibration causes small changes in the relative light collected by first and second photodetectors 35 and 40.

Light modulation depth in such optical pickup systems is generally quite small and the total LED signal collected by the photodetectors is only slightly modulated due to the small string vibration amplitude. The relatively strong common optical signal that is detected by each of series-connected photodetectors 35 and 40 is beneficially negated by the invention and only the signal difference is amplified by the primary detection circuits.

When the invention is applied to stringed instruments, the oscillating vibration of a string of a musical instrument can be leveraged by the mechanical configuration of the two photodetectors 35 and 40 as taught in U.S. Pat. No. 10,878,790. Because the string is oscillating back and forth, the received optical signal on each photodetector is temporally out of phase with the other by 180 degrees so that the signal resulting from the subtraction of the two signals on each of photodetector 35 and 40 comprises a signal with twice the amplitude as would result from use of a single photodetector.

Thus, the actual detected signal passed to the primary detection circuits in this embodiment has twice the amplitude and a higher modulation depth than prior art approaches because any signal that is common between the two photodetectors 35 and 40 is negated.

The instant invention beneficially doubles the signal amplitude for low modulation depth signals and thus provides a stronger detection signal. The invention also provides a higher fidelity string vibration reproduction since both extremes of the string's resonant oscillation are converted to current, i.e., converted to a summation of sinewaves that are more representative of the string vibration frequency content.

The invention further negates any common optical signal received by each of the photodetectors 35 and 40 and negates the low modulation depth portion of the collected light so that high gain can be implemented in the TIA. The invention yet further negates strong out-of-band signals as may arise from house lighting, the sun, or from camera flashes. This serves to minimize debiasing concerns in the first and second photodetectors 35 and 40.

In the same way a common signal reflecting off of the string is negated, the invention negates the impact of optical reflections from nearby objects or surfaces from saturating the primary detection circuits. As an example, light from a hand passing over the musical instrument string can be reflected into both photodetectors 35 and 40. In this embodiment, the portion of the signal reflected from the hand is reflected into both series-connected photodetectors 35 and 40 and is negated.

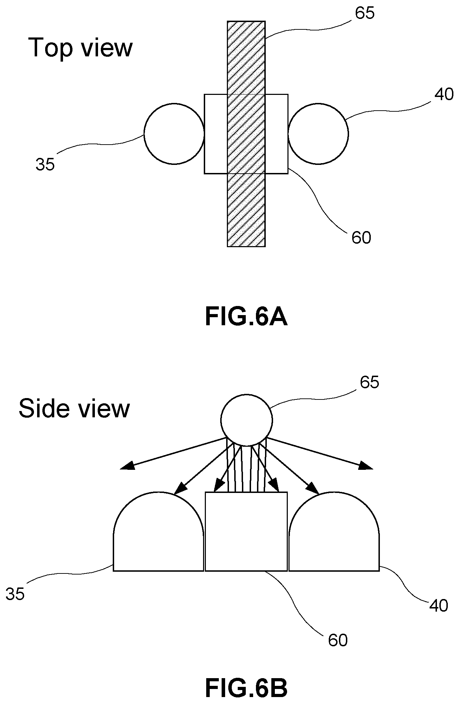

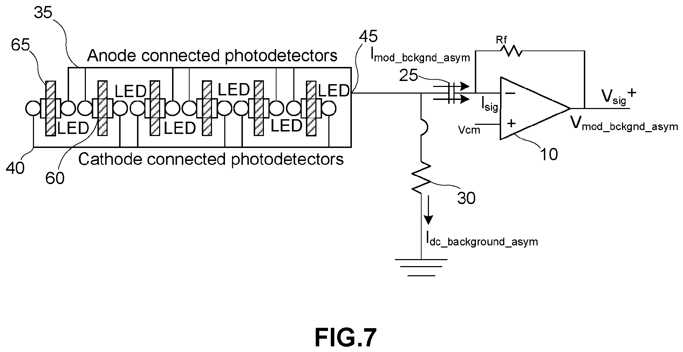

The optical pickup configuration of Fig. 6A and Fig. 6B improves on the configuration taught in Figs. 7A-C of U.S. Pat. No. 10,878,790 with respect to LED 60 and photodetector orientation for the reflection mode optical signal collection by the photodetectors 35 and 40. In this implementation, the device of Fig. 6A and 6B minimizes lateral light injection from the LED 60 directly into both of the series-connected photodetectors 35 and 40.

In the pickup configuration taught in Figs. 7A-C of U.S. Pat. No. 10,878,790, the LED emission is modulated by a sine wave at about 200 kHz to produce an amplitude modulated carrier signal. The TIA output is connected to an AM demodulator circuit (also referred to as a "product detector" herein) as per the '790 patent.

In Fig. 6A and Fig. 6B, LED 60 is oriented with respect to string 65 to avoid acting as a direct input as an optical signal into photodetectors 35 and 40. Even assuming this was the case, the symmetry of the illustrated system of Fig. 6A and Fig. 6B causes the amount of light incident upon both photodetectors 35 and 40 to be approximately the same and hence negated by the circuit of the present invention.

In applications that operate using incident light that is reflected from the surface of string 65 of an instrument, the intensity of the output of LED 60 may be high and undesirable shot noise resulting from a direct illumination of the LED signal may occur. Accordingly, in a reflection-based design, the LED 60 and photodetector 35 and 40 packages and positions are preferably selected to avoid direct illumination of the photodetectors.

On the other hand, in direct illumination/transmissive mode applications, the fraction of light collected by photodetectors 35 and 40 is much higher such that the circuit gain and LED power may be selected for use in a system where LED shot noise is not a significant consideration.

The LED 60 output in a reflective mode embodiment is directed upon and is incident on string 65. The emitted light reflects off string 65 at an angle determined not only by the light's incidence angle on string 65, but by the surface shape and texture of string 65 itself. If string 65 is oriented approximately midway between the two photodetectors 35 and 40, the amount of light reflected onto each photodetector is largely symmetric and a majority of the asymmetric signal is due to the motion of string 65 as it vibrates. The present invention enables the negation of the symmetric portions of the detected light and the doubling of the asymmetric portions of the signal to more accurately replicate string 65 vibration amplitude and vibration frequencies.

As disclosed in U.S. Pat. No. 10,878,790, a multiple dual photodetector approach using "banks" of photodetectors is disclosed and is consistent with the invention. The musical instrument pickup configurations of Figs. 6A-C, 7A-C, 8, and 10A-B of U.S. Pat. No. 10,878,790 are also generally compatible with the approach of the instant invention.

Further, any number of photodetectors can be configured in parallel in this invention so long as the sets of series-connected photodetectors comprise a single connection node 45 to the primary detection circuits at the first anode 35' of the first photodetectors in a first photodetector bank and the second cathode 40" of the second photodetectors in a second photodetector bank.

In the embodiment of Figs 6A and 6B, as optically reflective string 65 vibrates, the amount of light collected by first photodetector 35 and second photodetector 40 will differ. In other words, while the signal reflected from string 65 received by first photodetector 35 is waxing, the signal received by second photodetector 40 is simultaneously waning and vice versa.

The present invention effectively subtracts the waning signal from the waxing signal, cancelling or negating the signal generated by any unwanted incoming light that is collected due to the static arrangement of the system elements and instead, amplifies only the difference signal. With correct alignment and design, the difference signal is primarily comprised of only the signal resulting from the vibration of string 65. If external background light is present (e.g., room lights or sunlight), it will largely be common to both photodetectors 35 and 40 and negated by the present invention.

When the series-connected photodetectors of the invention are implemented in the prior art circuits of Figs. 1A, 2A and 3A herein, first photodetector 35 produces a current signal that is "π" out of phase with the current signal produced by second photodetector 40, i.e., the circuit subtracts the two out-of-phase current signals. In this example using a transconductance conversion of current-to-voltage via the TIA, the two current signals are amplified by -Rf.

When the series-connected photodetectors 35 and 40 of the inventions are incorporated into the string vibration detection circuitry, the currents from the first detector and the second detector are amplified with the same magnitude but opposite signs (negative for the first detector and positive for the second detector). In this example, using a transimpedance conversion of the current-to-voltage via the TIA, the two currents are amplified by -Rf and +Rf respectively. The combination or summation of these two amplified signals by the TIA or other amplifier results in their exact cancellation if they are identical and of the same phase or their doubling in magnitude if they are identical and $\pi$ out of phase.

The equations below set forth the mathematics of how the invention produces a signal voltage that is twice the desired signal amplitude while negating the undesired background signal. This is the case regardless of whether the background signal is in-phase or out-of-phase, so long as the background signal is symmetric with respect to both series-connected photodetectors. The undesired background signal can include modulated LED light, room lights, sunlight, or any other in-band optical signal that produces signal $I_{background}$.

$$I_{det1} = I_{Sig1} + I_{background}; \; I_{det2} = I_{Sig2} + I_{background}$$

$$I_{det1} = A \sin(\omega t) + I_{background}; \; I_{det2} = A \sin(\omega t + \pi) + I_{background}$$

$$V_{sig} = -R_f (I_{det1} - I_{det2})$$

$$I_{det1} - I_{det2} = A \sin(\omega t) - A \sin(\omega t + \pi) = 2A \sin\frac{1}{2}(-\pi) \cos\frac{1}{2}(2\omega t + \pi) = -2A \cos\left(\omega t + \frac{\pi}{2}\right) = 2A \sin \omega t$$

$$V_{sig} = -2A \, R_f \sin(\omega t)$$

Fig. 7 illustrates a non-limiting six-string reflected light geometry embodiment which, for purposes of conciseness, does not show all elements but teaches a preferred embodiment using a parallel-connected banks of photodetectors comprising a plurality of pairs of series-connected first and second photodetectors 35 and 40.

In the embodiment of Fig. 7, twelve photodetectors are illustrated and are connected in series as two banks of six pairs of parallel photodetectors. The banks are arranged with one series-connected pair of photodetectors per string 65 wherein first anodes 35' of first photodetectors 35 are electrically coupled to second cathodes 40" of second photodetectors 40. It is noted the invention is not limited to this configuration and that any number of user-defined series-connected photodetectors and any number of user-defined photodetector banks may be used. Further, all of the photodetectors in a stringed instrument application may be electrically coupled to the same TIA in one embodiment. This is preferably accomplished by connecting two sets of a user-defined number of parallel-connected photodetectors, each of which are connected in series as taught in Fig. 5. In the illustrated embodiment of Fig. 7, the photodetectors may be arranged with one (or more) of each of the two parallel groupings per string 65.

A beneficial aspect of the disclosed invention is that only the device capacitance, dark current noise, and trace inductance of the associated components limit the number of photodetectors that can be used. Background signal levels, though negated, may still contribute optical shot noise that can be amplified and there are limits as to how much background light to collect. This may limit the total number of photodetectors in a system or the maximum size of the photodetectors per TIA connection.

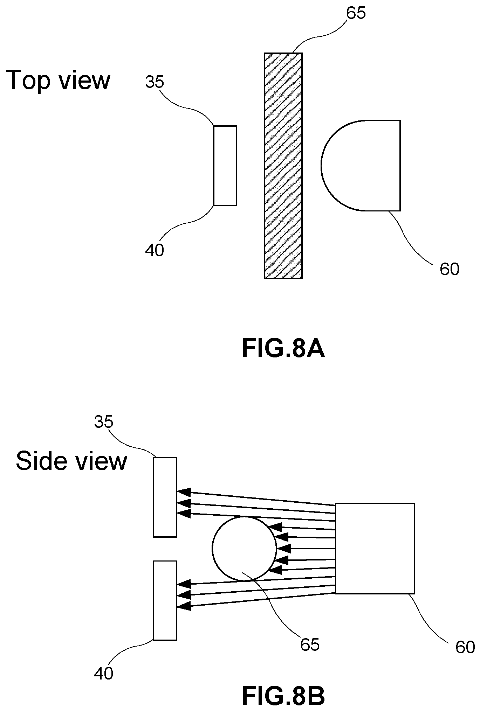

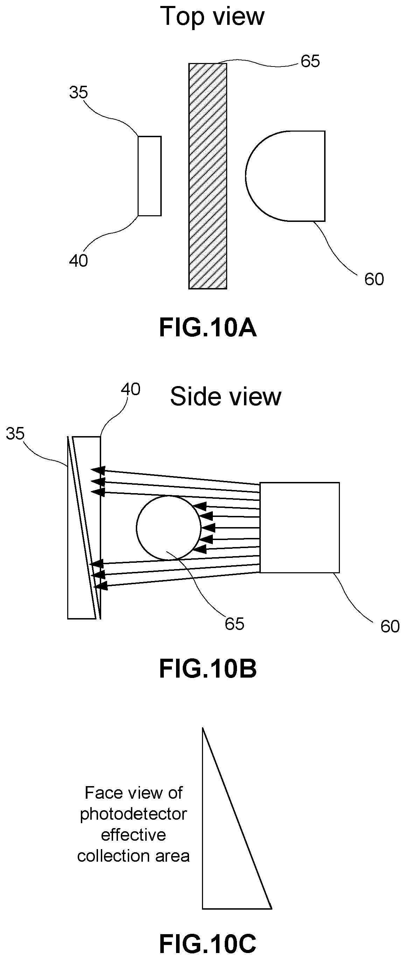

Fig. 8A and Fig. 8B herein builds upon Fig. 10A and Fig. 10B of the '790 patent for the transmissive mode collection of optical signals by the associated photodetectors. The present invention may be applied identically to such configurations using series-connected photodetectors.

Non-reflective/transmissive optical detection configurations such as shown in Fig. 10A and Fig. 10B of the '790 patent, are consistent with the present invention. When the series-connected photodetectors 35 and 40 of the invention herein are incorporated in a transmissive mode embodiment, LED 60 emits light toward the system's first and second photodetectors 35 and 40. In such an embodiment, photodetectors 35 and 40 and LED 60 are arranged so that when in a resting condition, the majority of the detected light is approximately balanced between first photodetector 35 that is electrically coupled to second photodetector 40.

Note that first photodetector 35 and second photodetector 40 are effectively electrical connections in the circuit and need not be individual elements. They may be comprised of arrays or banks of photodetectors and not all photodetectors need to be of the same design. The primary detection circuit does not differentiate how the received current or signal was created or which photodetector it comes from, rather it only sees the properties of the in-band signals it receives.

In a transmissive mode instantiation, string 65 vibration causes the signal on first photodetector 35 to wane while the received signal on second photodetector 40 waxes, i.e., the shadow falling on each of first photodetector 35 and second photodetector 40 varies over time by an equal but opposing degree as string 65 vibrates. In the same manner, any common light that is present in the resting position and that is not due to string vibration is negated by subtraction circuitry and the signals generated due to string vibration are doubled in amplitude.

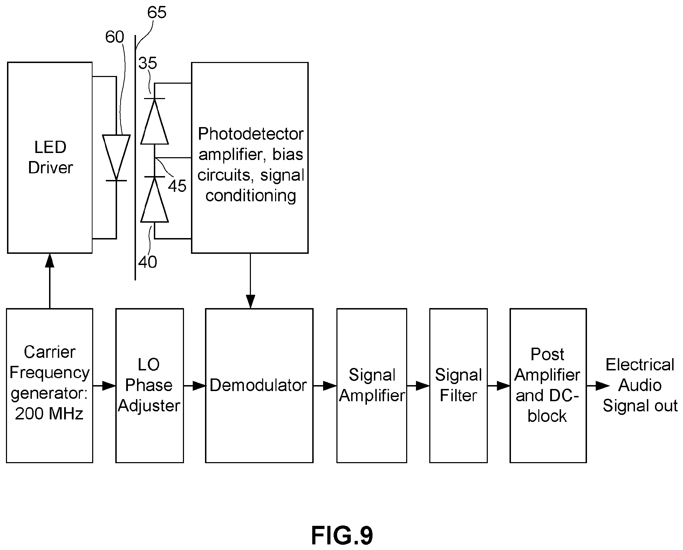

With respect to Fig. 9, an exemplar optical pickup system block diagram using a single string 65 of a musical instrument is shown. In the illustrated optical pickup configuration, a local oscillator (LO) output is delivered to a mixer and is phase delayed in order to align in-phase or out-of-phase with the detected and amplified signal. In other configurations, the amplified signal itself is used as a local oscillator signal source, typically comprising the addition of appropriate amplifier and limiter circuits.

The phase adjuster circuitry of Fig. 9 acts on the signal used to modulate LED 65 or on the LO output that is delivered to the demodulator. A consideration in this embodiment is that the demodulator receives a local oscillator output and conditions signals that are of the appropriate strength and phase alignment necessary to produce the desired output baseband signal.

In certain cases, a signal amplifier is not required after the demodulator in circuits where the output of the demodulator is sufficient for adequate signal transmission to downstream circuits.

In certain other cases, the signal conditioning of the photodetector current is accomplished using the conversion of the photodetector current to a voltage by means of op-amp circuitry in a TIA configuration. Other types of transconductance gain may be employed, including basic transistor devices. Suitable photodetectors may be of the PIN type, APD type, or devices such as phototransistors. The demodulator is this embodiment is commonly of a product detector configuration.

Fig. 10A, Fig. 10B and Fig. 10C illustrate a non-limiting alternative physical arrangement of first and second photodetectors 35 and 40 and designs of photodetector packages and lenses that may be employed in the invention. Each of the photodetector elements need not be uniformly positioned or shaped. The design of the photodetector elements and their placement may be manipulated to achieve a predetermined difference in optical signal current that is collected from each first photodetector 35 and second photodetector 40 (or banks of photodetectors) so that, as the string of the musical instrument vibrates, the optical input signal is collected with maximum efficiency. User-defined photodetector arrangements and designs can be adapted to facilitate different conditions conducive to manufacturability, assembly, alignment and the efficient operation of the system.

Fig. 10A, Fig. 10B and Fig. 10C show the use of photodetectors 35 and 40 having their optical collection surface area angularly disposed or tapered with respect to the LED 60 light source to expose different amounts of light collection areas, such as by means of appropriate optical arrangement.

In Fig. 10A, Fig. 10B and Fig. 10C, the light from LED 60 that is collected by photodetectors 35 and 40 is not reflected from string 65, but instead directly impinges upon the tapered surfaces of the photodetectors. As the shadows created by the oscillating string move across the tapered surfaces of first and second photodetectors 35 and 40, the light collected by first photodetector 35 and second photodetector 40 differs out of phase and hence the amplitude of the input signal is doubled.

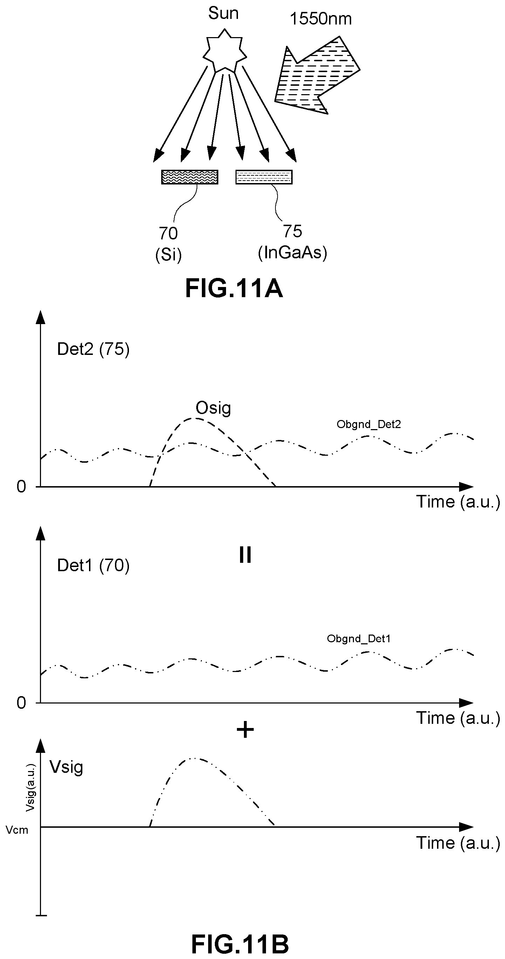

Turning now to Fig. 11A, the present invention can be generalized when considering the removal of the LED and the string presented in the prior embodiments of the invention. The topology of Fig. 5 is equally applicable to the fields of laser warning and free space optical communications and LIDAR/LADAR. In such applications, multiple photodetectors can be used to detect the impingement of photons received from lasers or other light sources rather than the source LED of the previously illustrated embodiments.

In free space systems, broadband detection is often desired because lasers emit light at a variety of wavelengths and therefor narrow band optical filtering is not easily employed when attempting to mitigate the detrimental effects of strong solar-induced background optical signals.

Broadband detection is desired in these systems due to the multiple laser wavelengths that are employed in free space applications. Typical laser wavelength ranges in free space applications are from 532 nm to 1550 nm, with 532 nm, 905 nm, 1064 nm, and 1550 nm wavelengths being the most common.

The present invention is readily generalized when a user considers the series-connected banks of photodetectors of the invention need not be all the same specification or design. This is discussed above but additional embodiments of the invention are described that take advantage of this feature. Mechanical or optical or material choices (e.g., filters or detector composition) can be incorporated to balance the background optical signals while allowing for the detection of desired optical signals.

The same invention configuration of Fig. 5 is applicable to free space detection applications along with the equations presented. The above-referenced equations show the electrical signals developed by the photodetectors due to background optical signals are negated while allowing desired light signals to be amplified, all while preventing debias of the photodetector elements in like manner as described in the above stringed instrument embodiments. Such free space detection systems may have optics to collect and focus light or may have optical diffusers to increase the field of regard. In all cases background optical signals are inevitable due to the exposure of the light collection system to the environment.

An alternative embodiment of the invention 100 is presented in Fig. 11A and Fig. 11B wherein the series-connected photodetector elements are of differing bandwidths. Here, a first photodetector bank of series-connected photodetectors may comprise one or more silicon photodetectors 70 (Det1) having a bandwidth from about 400 nm to about 1000 nm. The second photodetector bank may comprise, for example, one or more backside illuminated InGaAs photodetectors 75 (Det2) with an InP substrate design having a bandwidth from about 970 nm to about 1700 nm.

Because the two wavelength spans and photodetector bandwidths are not identical, and because the sun's power density emission at sea level is not uniformly distributed between these bands at all times and locations on Earth, there is an imperfect symmetry between the background optical signals that are collected due to sunlight.

Nonetheless, the invention greatly reduces the amount of DC signal produced by first photodetector bank 70 and second photodetector bank 75, enabling greater design freedom in the selection of the Rbias value without as much concern for loss of detector bias due to strong sunlight. In addition, a user can specify the various photodetectors and use optical filtering and other means to obtain current levels sufficient to permit background signal negation and eliminate many of the problems produced by bright sunlight.

Under certain conditions, sunlight may produce an in-band signal due to environmental effects such as a reflection off of a moving object, e.g., the reflective slates of a fence, or the moving of shadows due to sunlight passing through a set of rotating helicopter blades. In such cases, the present invention assists in negating the majority of the undesired in-band signal and prevents it from passing to the primary detection circuits.

This aspect of the invention permits the use of different wavelength detection ranges for series-connected photodetectors and enables additional design options. For example, when an in-band pulsed laser falls within the bandwidth of just one of the photodetector pairs in a bank, the output amplified signal from the TIA (in the case of the use of PIN detectors) can be either positive-going or negative-going, depending on which photodetector bandwidth the laser pulse overlaps.

Further embodiments of the invention may comprise the use of optical bandpass filters to change or modify the bandwidths of the series-connected photodetectors. Further embodiments of the invention may comprise the physical placement of the photodetectors or banks of photodetectors to alter the incidence angle of received optical signals while maintaining comparable negation of undesired background optical signals.

In the general sense of the invention, the use of the electrical signal present at connection node 45 between the photodetector pairs generates a voltage from the signal conditioning block. The resultant positive-going or negative-going voltage swing is used to determine which photodetector or bank of photodetectors received the optical signal. Numerous techniques can be used to modify which photodetector bank receives the optical signal versus the other and may include mechanical placement of the photodetector elements, optical filtering, photodetector compositions and specifications.

Referring back to Fig. 11A and 11B, the exemplar laser detection system is depicted for the negation of solar background signals and provides information regarding the optical bandwidth of the detected optical signal for the case of a 1550 nm laser pulse.

Osig in this example falls within the optical wavelength bandwidth of InGaAs photodetector 75 and comprises a 1550 nm pulsed laser beam. Osig is received by both silicon photodetector 70 and InGaAs photodetector 75 but is only absorbed by InGaAs photodetector 75. Obkgnd is also received by silicon photodetector 70 and InGaAs photodetector 75. The respective photodetectors or banks thereof, absorb and generate current proportional to the portion of Obkgnd within the optical bandwidth of each of the photodetector elements.

In this alternative preferred embodiment, a positive rising voltage pulse is produced above the Vcm of the TIA circuit as seen in Fig. 11B such that the primary detection circuits are able to differentiate the optical signal that is within the bandwidth of the InGaAs photodetector 75 and not within the bandwidth of the silicon photodetector 70.

Fig. 12A and Fig. 12B show alternate laser detection systems for the negation of solar background optical signals and provides information regarding the optical bandwidth of the detected optical signal for a different case from that of Fig. 11A of a 905 nm laser pulse. This embodiment may comprise a silicon photodetector 70 (Det1) having a bandwidth of about 450 nm to about 1000 nm. The embodiment may further comprise a backside illuminated InGaAs photodetector with an InP substrate 75 (Det2) having a bandwidth of about 980 nm to about 1700 nm.

Osig in Fig. 12A comprises an optical wavelength bandwidth of the series-connected silicon photodetector 70, i.e., about 450 nm to about 1000 nm wherein a 905 nm pulsed laser beam is incident upon silicon photodetector 70. Osig is received by silicon photodetector 70 and InGaAs photodetector 75 but is only absorbed by silicon photodetector 70. Obkgnd is received by silicon photodetector 70 and InGaAs photodetector 75 and each photodetector absorbs and generates current proportional to the portion of Obkgnd within the optical bandwidth of each photodetector element. The circuit of Fig. 12A is the same as that of Fig. 11A with the difference being the wavelength of the laser pulse being received.

In the example of Fig. 12B, a negative-going voltage pulse is produced below the Vcm of the TIA circuit such that the primary detection circuits are able to differentiate the optical signal that is within the bandwidth of the silicon photodetector 70 and not within the bandwidth of the InGaAs photodetector 75.

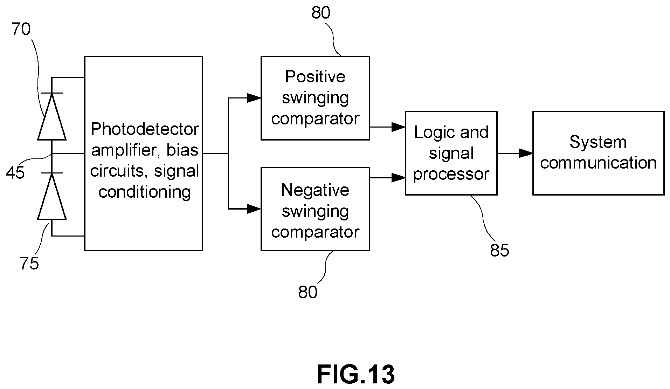

Fig. 13 shows an alternative preferred embodiment of a system architecture for a laser warning system capable of differentiating which bank of series-connected photodetectors 70 and 75 of Fig. 11A and Fig. 12A receives an incoming laser pulse by means of a voltage swing direction of the resultant amplified electrical signal.

Fig. 13 illustrates the use of dual comparators 80 and 80' after signal conditioning elements (for example, a TIA) and configures them to identify different voltage swing directions with respect to the common mode output voltage swing of the TIA. Invention 100 of Fig. 5 provides a useful topology for application in the circuit of Fig. 13, which in turn enables the operation of the circuits illustrated in Fig. 11A and Fig. 12A. The subsequent logic blocks 85 are provided and record and communicate this information. In this way, the invention provides information about which photodetector bank received the optical signal.

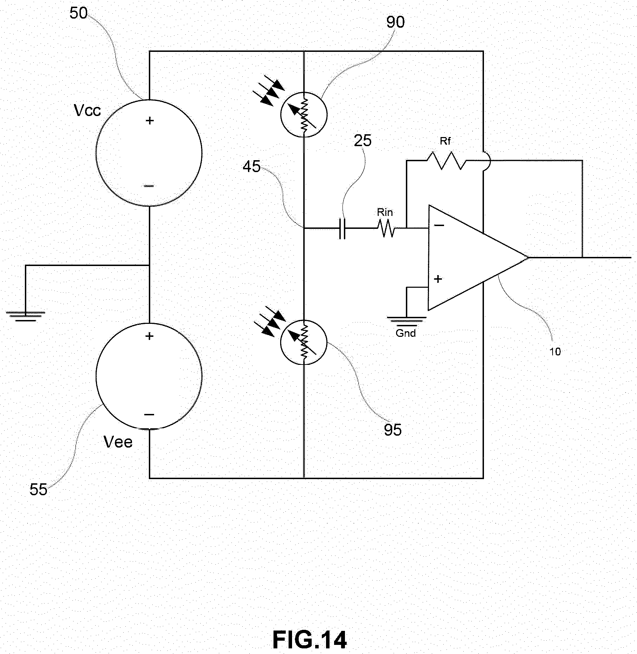

An alternative embodiment of invention 100 illustrated in Fig. 14 may comprise a pair of series-connected light dependent resistor elements (LDR). In this embodiment, two LDRs 90 and 95 create a variable voltage divider wherein the current through each LDR element 90 and 95 varies with the amount of light incident upon the respective LDRs. The current through LDRs 90 and 95 acts to cancel out any common background signal between them, both DC and in-band signals.

When the invention incorporates a pair of series-connected photoconductor elements such as LDRs, the voltage at connection node 45 connection varies. An AC voltage amplifier is used to amplify the voltage swing produced at connection node 45. The two LDRs 90 and 95 form a voltage divider and the respective through-currents cancel as described before.

An asymmetric modulated background signal causes the voltage at the series connection to swing and the AC portion to pass through AC-coupling capacitor Cblock 25 whereby op amp 10 amplifies the voltage by -Rf/Rin. In this example a dual volage rail op amp may be used. This dual voltage op amp can be used for other embodiments disclosed herein.

Because the effective resistance of each LDR element 90 and 95 is changing due to varying incident light, the desired signal constantly sees a different resistance to ground, so the voltage at connection node 45 is changing such that the use a transimpedance amplifier may not function optimally in all applications. A voltage amplifier may be utilized effectively for amplification of the signal in such an embodiment. Thus, the photoconductive LDR light cells may be used with a TIA or a voltage amplifier and both can be built with standard operational amplifiers or transistor level designs.

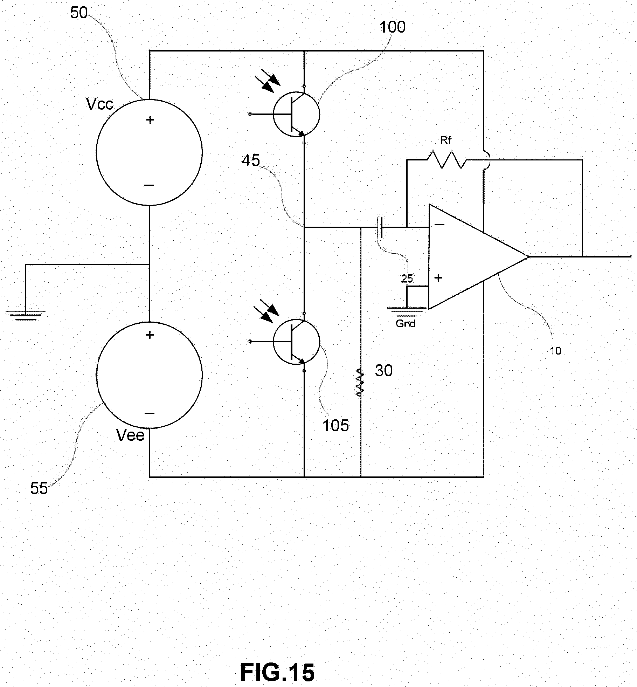

An alternative photojunction device to the photodiodes of the invention may further comprise a pair of series-connected phototransistors 100 and 105 such as is illustrated in Fig. 15. Such an embodiment may be viewed as a pair of photodiodes having amplification. A phototransistor light sensor element comprises a collector-base PN-junction that is reverse biased, exposing it to the radiant light source.

With sufficient positive voltage across the collector and emitter of phototransistors 100 and 105, the current is proportional to the incident light upon them, just as with a PN junction and other junction-based photodetectors.

Phototransistors function similar to a photodiode but provide current gain and are much more sensitive than the photodiode with currents much greater than that of a photodiode.

Photodarlington transistors and photothyristors are also suitable light sensitive elements for use in the invention. Photodarlington transistors comprise a second bipolar NPN transistor for additional amplification or when higher sensitivity of a photodetector is required due to low light levels or selective sensitivity, but response for these devices tends to be slower than that of an ordinary NPN phototransistor.

Another type of photojunction semiconductor light sensor which may be incorporated in the invention is a photothyristor. A photothyristor is a light activated thyristor or silicon-controlled rectifier (SCR) often used as a light-activated switch in AC applications. However, the light sensitivity of an SCR is usually very low compared to equivalent photodiodes or phototransistors.

For the above photojunction phototransistor, photodarlington transistor and photothyristor devices, application of a voltage across them allows current to flow in response. The difference between the junction-based devices is whether they provide their own current gain verses the gain relative to the amount of light impinging on them. These devices still require a positive voltage across them to obtain the current gain. The current must be eventually converted to a voltage signal. This conversion may be accomplished by means of a simple load resistor to achieve the transconductance or by means of a transimpedance amplifier.

All of the above light sensing devices comprise a higher voltage terminal and a lower voltage terminal to achieve the desired response and to convert the incident light signal into an electrical signal. Hence each of the above light sensing devices advantageously comprises a high-voltage contact and a low-voltage contact when incorporated into the circuit of the invention 100.

In the foregoing specification, embodiments of the invention have been described with reference to specific exemplary embodiments thereof. It will be evident that various modifications may be made thereto without departing from the broader spirit and scope of the invention as set forth in the following claims. The specification and drawings are, accordingly, to be regarded in an illustrative sense rather than a restrictive sense.

Many alterations and modifications may be made by persons having ordinary skill in the art without departing from the spirit and scope of the invention. Therefore, it must be understood that the illustrated embodiments have been set forth only for the purposes of example and that it should not be taken as limiting the invention as defined by any claims in any subsequent application claiming priority to this application.

For example, notwithstanding the fact that the elements or limitations of a claim may be set forth in a certain combination, it must be expressly understood that the invention includes other combinations of fewer, more or different elements or limitations, which are disclosed above even when not initially claimed in such combinations.

The words used in this specification to describe the invention and its various embodiments are to be understood not only in the sense of their commonly defined meanings, but to include by special definition in this specification structure, material or acts beyond the scope of the commonly defined meanings. Thus, if an element can be understood in the context of this specification as including more than one meaning, then its use in a subsequent claim must be understood as being generic to all possible meanings supported by the specification and by the word itself.

The definitions of the words or elements of any claims in any subsequent application claiming priority to this application should be, therefore, defined to include not only the combination of elements which are literally set forth, but all equivalent structures, materials or acts for performing substantially the same function in substantially the same way to obtain substantially the same result. In this sense, it is therefore contemplated that an equivalent substitution of two or more elements may be made for any one of the elements in such claims below or that a single element may be substituted for two or more elements in such a claim.

Although elements may be described above as acting in certain combinations and even subsequently claimed as such, it is to be expressly understood that one or more elements from a claimed combination can in some cases be excised from the combination and that such claimed combination may be directed to a sub-combination or variation of a sub-combination.

Insubstantial changes from any subsequently claimed subject matter as viewed by a person with ordinary skill in the art, now known or later devised, are expressly contemplated as being equivalently within the scope of such claims. Therefore, obvious substitutions now or later known to one with ordinary skill in the art are defined to be within the scope of the defined elements.

Any claims in any subsequent application claiming priority to this application are thus to be understood to include what is specifically illustrated and described above, what is conceptually equivalent, what can be obviously substituted and also what essentially incorporates the essential idea of the invention.

There may be provided an optical sensor circuit having improved background signal cancellation comprising:

a first photodetector comprising a first anode;
a second photodetector comprising a second cathode;
the first photodetector and the second photodetector connected in series by means of electrically coupling the first anode to the second cathode to define a connection node,
the connection node electrically coupled to a predetermined low impedance reference voltage by means of a bias resistor;
circuit means comprising an input and an output
the connection node and the input electrically coupled by means of a DC-blocking capacitor; bias means to maintain a first bias on the first photodetector and a second bias on the second photodetector;
whereby an electrical signal representative of a difference in an optical signal received by the first photodetector and the second photodetector at the connection node is present at the output by the circuit means.

The circuit means may comprise an operational amplifier configured as a transimpedance amplifier comprising an inverting input and output.

The first photodetector may be responsive to a first range of optical wavelengths and the second photodetector may be responsive to a second range of optical wavelengths that is different from the first range of optical wavelengths.

The first photodetector may be a silicon (Si) photodetector and the second photodetector may be an indium gallium arsenide (InGaAs) photodetector.

The circuit may further comprise a light emitting source comprising a light output incident upon the first photodetector and the second photodetector.

The light output may comprise a modulated output.

At least one of the first photodetector and second photodetector may be comprised of a tapered light collection surface.

An intensity of the modulated output incident upon the first photodetector and an intensity of the modulated output incident upon the second photodetector may vary in proportion to a reflection of the modulated output received from a surface of a vibrating string of a musical instrument.

An intensity of the modulated output incident upon the first photodetector and an intensity of the modulated output incident upon the second photodetector may vary in proportion to a varying optical power of the modulated output resulting from a vibrating string of a musical instrument.

There may be provided a multi-bank optical sensor circuit having improved background signal cancellation comprising:

a plurality of optical sensor circuit subassemblies wherein each subassembly comprises;
a first photodetector comprising a first anode;
a second photodetector comprising a second cathode;

the first photodetector and the second photodetector connected in series by means of electrically coupling the first anode to the second cathode to define a connection node,

wherein the first anode of each subassembly is electrically coupled to each of the other first anodes, wherein the second cathode of each subassembly is electrically coupled to each of the other second cathodes,

the multi-bank optical sensor circuit further comprising a bias resistor electrically coupled between the connection node and a predetermined low impedance reference voltage;

a DC-blocking capacitor electrically coupled between the connection node and the input;

bias means to maintain a first bias on the first photodetectors and a second bias on the second photodetectors;

whereby an electrical signal representative of a difference in an optical signal received by the first photodetector and the second photodetector at the connection node is present at the output by the circuit means.

The circuit means may comprise an operational amplifier configured as a transimpedance amplifier comprising and inverting input and an output.

The plurality of respective subassemblies further comprises one or a plurality of respective light emitting sources, an output of each of which is incident upon the respective ones of the plurality of first photodetectors and is incident upon the respective ones of the plurality of second photodetectors.

At least one light emitting source may comprise a modulated output.

At least one of the first photodetectors or at least one of the second photodetectors may be comprised of a tapered light collection surface.

An intensity of the modulated output incident on the respective ones of the plurality of first photodetectors and on the respective ones of the plurality of second photodetectors may vary in proportion to a reflection of the modulated output received from a surface of a vibrating of a string of a musical instrument.

An intensity of the modulated output that is incident upon the plurality of first photodetectors and upon the plurality of second photodetectors may vary in proportion to a varying optical power of the modulated output resulting from a vibrating string of a musical instrument.

At least one of the first photodetectors or at least one of the second photodetectors may comprise a tapered light collection surface.

At least one first photodetector may be responsive to a first range of optical wavelengths and at least one second photodetector may be responsive to a second range of optical wavelengths that is different from the first range of optical wavelengths.

At least one first photodetector may be a silicon (Si) photodetector and at least one second photodetector may be an indium gallium arsenide (InGaAs) photodetector.

The circuit may further comprise voltage swing direction detection means configured whereby a positive-going or a negative-going voltage swing at the connection node is used to determine which photodetector or bank of photodetectors received an optical signal comprising a user-defined optical characteristic.

There is also provided an optical sensor circuit having improved background signal cancellation comprising:

a first photodetector having a first low voltage side connection;

a second photodetector having a second high voltage side connection;

the first photodetector and the second photodetector connected in series by means of electrically coupling the first low voltage side connection to the second high voltage side connection to define a connection node,

the connection node and the input electrically coupled by means of a DC-blocking capacitor;

bias means to maintain a first bias on the first photodetector and a second bias on the second photodetector;

whereby an electrical signal representative of a difference in an optical signal received by the first photodetector and the second photodetector at the connection node is present at the output by the circuit means.

The connection node may be electrically coupled to a predetermined low impedance reference voltage by means of a bias resistor.

12. The first photodetector may be located on a first side of the light emitting source and the second photodetector may be located on a second side of the light emitting source opposite the first side, wherein light provided by the light emitting source may be reflected by a string of an instrument to the first photodetector and the second photodetector.

The first photodetector and the second photodetector may be positioned facing the light emitting source across a gap configured to receive a string of a stringed instrument, wherein the first photodetector and second photodetector may be configured to receive transmissive light from the light emitting source.

At least one of the first photodetectors or at least one of the second photodetectors may be comprised of a tapered light collection surface.

**Claims**

1. An optical sensor circuit having improved background signal cancellation comprising:

   a first photodetector (35) comprising a first anode;
   a second photodetector (40) comprising a second cathode (40");the first photodetector (35) and the second photodetector (40) connected in series by means of electrically coupling the first anode (35') to the second cathode (40") to define a connection node (45), the connection node (45) electrically coupled to a predetermined low impedance reference voltage by means of a bias circuit (30);circuit means (10) comprising an input and an output, the connection node (45) and the input electrically coupled by means of a DC-blocking capacitor (25); bias means (50, 55) to maintain a first bias on the first photodetector (35) and a second bias on the second photodetector (40);
   whereby an electrical signal representative of a difference in an optical signal received by the first photodetector (35) and the second photodetector (40) at the connection node (45) is present at the output by the circuit means (10).

2. The circuit of claim 1, wherein the circuit means (10) comprises an operational amplifier (10) configured as a transimpedance amplifier comprising an inverting input and output.

3. The circuit of claim 2, wherein the first photodetector (35) is responsive to a first range of optical wavelengths and the second photodetector (40) is responsive to a second range of optical wavelengths that is different from the first range of optical wavelengths.

4. The circuit of claim 3, wherein the first photodetector (35) is a silicon (Si) photodetector and the second photodetector (40) is an indium gallium arsenide (InGaAs) photodetector.

5. The circuit of claims 1 or 2 further comprising a light emitting source (60) comprising a light output incident upon the first photodetector (35) and the second photodetector (40), wherein the light output comprises a modulated output.

6. The circuit of claim 5 wherein at least one of the first photodetector (35) and second photodetector (40) is comprised of a tapered light collection surface.

7. The circuit of claims 5 or 6 wherein an intensity of the modulated output incident upon the first photodetector (35) and an intensity of the modulated output incident upon the second photodetector (40) varies in proportion to a reflection of the modulated output received from a surface of a vibrating string (65) of a musical instrument or varies in proportion to a varying optical power of the modulated output resulting from a vibrating string (65) of a musical instrument.

8. A multi-bank optical sensor circuit having improved background signal cancellation comprising:

   a plurality of optical sensor circuit subassemblies wherein each subassembly comprises:

   a first photodetector (35) comprising a first anode (35') ) responsive to a first range of optical wavelengths;
   a second photodetector (40) comprising a second cathode (40") responsive to a second range of optical wavelengths different from the first range of optical wavelengths;
   the first photodetector (35) and the second photodetector (40) connected in series by means of electrically coupling the first anode (35') to the second cathode (40") to define a connection node (45), wherein the first anode (35') of each subassembly is electrically coupled to each of the other first anodes, wherein the second cathode (40") of each subassembly is electrically coupled to each of the other second cathodes,

   circuit means (10) comprising an input and an output;
   a bias circuit (30) electrically coupled between the connection node (45) and a predetermined low impedance reference voltage;
   a DC-blocking capacitor (25) electrically coupled between the connection node (45) and the input of the circuit means (10);
   bias means (50, 55) to maintain a first bias on the first photodetectors (35) and a second bias on the second photodetectors (40);
   whereby an electrical signal representative of a difference in an optical signal received by the first photodetector (35) and the second photodetector (40) at the connection node (45) is present at the output by the circuit means (10).

9. The circuit of claim 8 wherein the circuit means (10) comprises an operational amplifier (10) configured as a transimpedance amplifier comprising and inverting input and an output.

10. The circuit of claims 8 or 9, wherein at least one first photodetector (35) is a silicon (Si) photodetector and at least one second photodetector (40) is an indium gallium arsenide (InGaAs) photodetector.

11. The circuit of claims 8, 9, or 10, further comprising voltage swing direction detection means (80) configured whereby a positive-going or a negative-going voltage swing at the connection node (45) is used to determine which photodetector or bank of photodetectors received an optical signal comprising a user-defined optical characteristic.

12. The circuit of claims 5, 6, or 7, wherein the first photodetector (35) is located on a first side of the light emitting source (60) and the second photodetector (40) is located on a second side of the light emitting source (60) opposite the first side, wherein light provided by the light emitting source (60) is reflected by a string of an instrument to the first photodetector (35) and the second photodetector (40).

13. The circuit of claims 5, 6, or 7, wherein the first photodetector (35) and the second photodetector (40) are positioned facing the light emitting source (60) across a gap configured to receive a string of a stringed instrument, wherein the first photodetector (35) and second photodetector (40) are configured to receive transmissive light from the light emitting source (60).

14. The circuit of claim 12 or 13, wherein at least one of the first photodetectors (35) or at least one of the second photodetectors (40) is comprised of a tapered light collection surface.

**FIG.1A**

Prior Art

**FIG.1B**

Prior Art

**FIG.2A**

Prior Art

**FIG.2B**

Prior Art

**FIG.3A**

Prior Art

**FIG.3B**

Prior Art

**FIG.3C**
Prior Art

**FIG.4A**
Prior Art

Vcm

Gnd

II

0

Vsig

Vbgnd

+

Vsig(a.u.)

Vcm

Time (a.u.)

Vsig

**FIG.4B**
Prior Art

FIG.5

Top view

65

40

35

60

**FIG.6A**

Side view

65

35

40

60

**FIG.6B**

**FIG.7**

**FIG.8A**

**FIG.8B**

FIG.9

## Top view

**FIG.10A**

## Side view

**FIG.10B**

Face view of
photodetector
effective
collection area

**FIG.10C**

Sun                1550nm

70
(Si)

75
(InGaAs)

**FIG.11A**

Det2 (75)

Osig

Obgnd_Det2

0

Time (a.u.)

**II**

Det1 (70)

Obgnd_Det1

0

Time (a.u.)

**+**

Vsig

Vsig(a.u.)

Vcm

Time (a.u.)

**FIG.11B**

**FIG.12A**

**FIG.12B**

70

45

75

Photodetector
amplifier, bias
circuits, signal
conditioning

80

Positive
swinging
comparator

Negative
swinging
comparator

80

Logic and
signal
processor

85

System
communication

**FIG.13**

**FIG.14**

**FIG.15**

Europäisches
Patentamt

European
Patent Office

Office européen
des brevets

# EUROPEAN SEARCH REPORT

**Application Number**

EP 25 18 4051

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/010302 A1 (SHARMA UTKARSH [US] ET AL) 10 January 2013 (2013-01-10) | 1-10, 12-14 | INV.<br>H03F3/08<br>H03F3/45 |
| A | * paragraphs [0004], [0005], [0007], [0052], [0067], [0069]; figures 2,8,14 * | 11 | |
| X | CN 114 858 274 A (UNIV SHANGHAI TECHNOLOGY) 5 August 2022 (2022-08-05) | 1,8 | |
| A | * paragraphs [0015], [0020], [0022], [0031]; figure 3 * | 2-7,9-14 | |
| X | US 2002/131135 A1 (CHOW ALAN Y [US] ET AL) 19 September 2002 (2002-09-19) | 1,8 | |
| A | * paragraphs [0024], [0031], [0042], [0067], [0116]; figures 1,9,17A,17B, 18 * | 2-7,9-14 | |
| A | US 2018/269250 A1 (CHOW VINCENT Y [US]) 20 September 2018 (2018-09-20) * paragraphs [0009], [0052]; figures 1,3A,4A * | 1-14 | |
| A | US 10 878 790 B1 (GESKE JONATHAN C [US] ET AL) 29 December 2020 (2020-12-29) * abstract; figure 10B * | 1-14 | **TECHNICAL FIELDS SEARCHED (IPC)**<br><br>H03F |

The present search report has been drawn up for all claims

| Place of search | Date of completion of the search | Examiner |
|---|---|---|
| The Hague | 11 November 2025 | Zakharian, Andre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 4051

This annex lists the patent family members relating to the patent documents cited in the above-mentioned European search report.
The members are as contained in the European Patent Office EDP file on
The European Patent Office is in no way liable for these particulars which are merely given for the purpose of information.

11-11-2025

| Patent document cited in search report | | Publication date | Patent family member(s) | | Publication date |
|---|---|---|---|---|---|
| US 2013010302 | A1 | 10-01-2013 | US 2013010302 A1 | | 10-01-2013 |
| | | | WO 2012168239 A1 | | 13-12-2012 |
| CN 114858274 | A | 05-08-2022 | NONE | | |
| US 2002131135 | A1 | 19-09-2002 | AU 2002306784 A1 | | 03-10-2002 |
| | | | US 2002131135 A1 | | 19-09-2002 |
| | | | WO 02075372 A2 | | 26-09-2002 |
| US 2018269250 | A1 | 20-09-2018 | US 2018266938 A1 | | 20-09-2018 |
| | | | US 2018269250 A1 | | 20-09-2018 |
| | | | US 2018270434 A1 | | 20-09-2018 |
| | | | US 2018270435 A1 | | 20-09-2018 |
| | | | WO 2018170232 A1 | | 20-09-2018 |
| | | | WO 2018170257 A1 | | 20-09-2018 |
| US 10878790 | B1 | 29-12-2020 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10878790 B, Geske